# EUROPÄISCHE PATENTSCHRIFT

(11) **EP 1 982 197 B1**
(45) Veröffentlichungstag und Bekanntmachung des Hinweises auf die Patenterteilung: **28.07.2010**
(21) Anmeldenummer: 06818561.0
(22) Anmeldetag: 15.11.2006
(51) Int. Cl.: G01R 1/067, G01R 31/28

(54) **FINGERTESTER ZUM PRÜFEN VON UNBESTÜCKTEN LEITERPLATTEN UND VERFAHREN ZUM PRÜFEN UNBESTÜCKTER LEITERPLATTEN MIT EINEM FINGERTESTER**
FINGER TESTER FOR TESTING UNPOPULATED PRINTED CIRCUIT BOARDS AND METHOD FOR TESTING UNPOPULATED PRINTED CIRCUIT BOARDS USING A FINGER TESTER
TESTEUR À PATTES POUR CONTRÔLER DES CARTES DE CIRCUITS IMPRIMÉS NON ÉQUIPÉES ET PROCÉDÉ DE CONTRÔLE DE CARTES DE CIRCUITS IMPRIMÉS NON ÉQUIPÉES AVEC UN TESTEUR À PATTES

(30) Priorität: 10.02.2006 DE 102006006255
(43) Veröffentlichungstag der Anmeldung: 22.10.2008
(73) Patentinhaber: atg Luther & Maelzer GmbH, 97877 Wertheim/Reicholzheim (DE)
(72) Erfinder: ROMANOV, Victor, 97877 Wertheim (DE)
(74) Vertreter: Ganahl, Bernhard
(86) Internationale Anmeldenummer: PCT/EP2006/010964
(87) Internationale Veröffentlichungsnummer: WO 2007/090447

(56) Entgegenhaltungen:
- EP-A- 0 989 409
- WO-A-03/096037
- DE-A1- 3 120 114

## Beschreibung

Die Erfindung betrifft einen Fingertester zum Prüfen von unbestückten Leiterplatten sowie ein Verfahren zum Prüfen von unbestückten Leiterplatten mit einem solchen Fingertester. Insbesondere betrifft die Erfindung einen Fingertester, der mehrere Prüffinger aufweist, die zum Kontaktieren von Leiterplattentestpunkten einer zu testenden Leiterplatte automatisch verfahren werden.

Prüfvorrichtungen zum Testen von Leiterplatten können grundsätzlich in zwei Gruppen eingeteilt werden, der Gruppe der Fingertester (Flying Probe) und der Gruppe der Paralleltester. Die Paralleltester sind Prüfvorrichtungen, die mittels eines Adapters alle oder zumindest die meisten Kontaktstellen einer zu prüfenden Leiterplatte gleichzeitig kontaktieren. Fingertester sind Prüfvorrichtungen zum Testen von unbestückten oder bestückten Leiterplatten, die mit zwei oder mehreren Prüffingern die einzelnen Kontaktstellen sequenziell abtasten.

Die Prüffinger sind in der Regel an einem Schlitten befestigt, welcher entlang von Traversen verfahrbar ist, wobei die Traversen wiederum auf Führungsschienen geführt und verfahrbar sind. Die Schlitten können somit an jede beliebige Stelle eines in der Regel rechteckförmigen Prüffeldes positioniert werden. Zum Kontaktieren einer Kontaktstelle einer zu prüfenden Leiterplatte ist entweder der Schlitten an der Traverse vertikal verschieblich oder die Prüfsonde am Schlitten vertikal beweglich ausgebildet, so dass der Prüffinger von oben bzw. von unten auf die Kontaktstelle der Leiterplatte, dem Leiterplattentestpunkt, gesetzt werden kann.

Ein Fingertester ist in der EP 0 468 153 A1 und ein Verfahren zum Prüfen von Leiterplatten mittels eines Fingertesters ist in der EP 0 853 242 A1 beschrieben.

Prüfsonden für Fingertester gehen aus der EP 1 451 594 B1, US 6,384,614 B1, WO 03/096037 A1 und der EP 0 990 912 A2 hervor.

Aus der EP 1 451 594 B1 geht eine Prüfsonde für einen Fingertester zum Testen von Leiterplatten hervor, die keinen Eigenantrieb aufweist. Die Prüfsonde ist mit einer Prüfnadel versehen, die mit einer Prüfspitze mit einem Leiterplattentestpunkt in Kontakt bringbar ist. Die Prüfnadel ist mit zumindest zwei Paar elastisch federnder Haltearme schwenkbar an einer Halterung befestigt, wobei zumindest einer der Haltearme aus einem elektrisch leitenden Material ausgebildet und mit der Prüfnadel elektrisch verbunden ist. Die Paare von Haltearmen spannen in einer Draufsicht ein Dreieck auf, so dass die Prüfsonde bei einem sehr geringen Gewicht, mit dem beim Kontaktieren die Leiterplatte beaufschlagt wird, dennoch eine hohe Torsionssteifigkeit besitzt, die ein seitliches Verrutschen der Prüfspitze beim Kontaktieren sicher verhindert.

Aus der WO 03/096037 A1 geht ein Fingertester und ein Verfahren zum Prüfen von Leiterplatten mit Hilfe eines Fingertesters hervor, bei dem jedem Prüffinger eine Kamera zugeordnet ist, die auf die Prüfspitze einer Prüfnadel fokussiert wird, sodass mit der Kamera eine Abweichung der Prüfspitze bezüglich eines zu kontaktierenden Leiterplattentestpunktes detektierbar ist und die Position des Prüffingers in der Ebene der Leiterplatte entsprechend korrigierbar ist. In diesem Dokument sind die Kameras schematisch in vertikaler Flucht über der jeweiligen Prüfspitze dargestellt. In der Praxis werden diese Kameras jedoch nicht in vertikaler Flucht über der Prüfspitze angeordnet, sondern seitlich etwas versetzt, sodass ihre Blickrichtung auf die Prüfspitze einen Winkel mit der Vertikalen einschließt, der etwa 30° bis 50° beträgt. Die Kameras blicken somit schräg auf die Prüfspitze der Prüfnadel. Hierdurch ist sicher gestellt, dass die Prüffinger mit ihren Kameras nicht kollidieren, selbst wenn sie zwei sehr eng nebeneinander liegende Leiterplattentestpunkte gleichzeitig kontaktieren. Diese Vorrichtung und das entsprechende Verfahren zum Korrigieren der Position der Prüfspitze hat sich in der Praxis sehr bewährt. Mit dem Verfahren können auch Kalibrierdaten gewonnen werden, die örtliche Relation zwischen den Kontaktspitzen der Prüfnadeln und den physikalischen Leiterplattentestpunkten der zu testenden Leiterplatte festlegen.

Weiterhin ist es bekannt, einen Fingertester mit einer Kamera zu versehen, die separat von den Prüffingern ausgebildet ist und die vor dem eigentlichen Testvorgang, bei dem die Leiterplattentestpunkte mit den Prüfnadeln kontaktiert werden, die Oberfläche der Leiterplatte vollständig erfasst. Hierzu wird die Kamera wie ein Prüffinger parallel zur Oberfläche verfahren. Diese Kamera ist mit ihrer Blickrichtung vertikal auf die Oberfläche der Leiterplatte ausgerichtet. Man erhält hierdurch ein vollständiges Bild der Oberfläche der Leiterplatte. Da die Kamera mit ihrer Blickrichtung vertikal auf die Oberfläche der Leiterplatte ausgerichtet ist, weist das von der Oberfläche der Leiterplatte erfasste Bild wesentlich weniger Verzerrungen auf als dies mit schräg an den Prüffingern angeordneten Kameras möglich ist. Eine vertikal auf der Oberfläche der Leiterplatte ausgerichtete Blickrichtung ist wünschenswert, da hierdurch die Qualität des von der Oberfläche der Leiterplatte erfassten Bildes wesentlich besser ist und ein Gesamtbild der Leiterplatte erzeugt werden kann, das in weitergehenden optischen Analysen einfacher verarbeitbar ist.

Es wäre deshalb ein großer Vorteil, wenn die Kamera zum Erfassen der Position der Prüfspitze der Prüfnadel mit vertikaler Blickrichtung bezüglich der Leiterplatte angeordnet wäre, da dann an einem Fingertester die zusätzliche Kamera zum Erfassen eines Gesamtbildes der Leiterplatte weggelassen werden könnte. Diese zusätzliche Kamera erfordert einen separaten Antriebsmechanismus, der kostbaren Raum im Fingertester beansprucht. Ein solches Gesamtbild der Leiterplatte könnte dann mit einer einem Prüffinger zugeordneten Kamera erfasst werden.

Aus der EP 1 122 546 A2 geht eine Testvorrichtung zum Testen von Leiterplatten hervor. Diese Testvorrichtung ist mit einer einzelnen Kamera versehen. Die Kamera tasted mittels eines schräg angeordneten Spiegels die Oberfläche eines Prüflings ab. Benachbart zum Spiegel sind Leuchtdioden als Lichtquellen angeordnet.

Aus der DE 31 20 114 A1 geht eine Anordnung und ein Verfahren zum Prüfen von Leiterbahnen bzw. den darauf angeordneten Netzwerken auf Durchgang und Kurzschluss hervor. Die Anordnung weist zum Beispiel vier sich parallel zueinander und aufeinander zu- bzw. voneinander weg verfahrbare Schlitten mit Tastspitzen auf. Jeweils zwei übereinander angeordnete Schlitten bilden dabei einen Doppelschlitten. Zwei Doppelschlitten sind spiegelbildlich zueinander angeordnet. Die Schlitten sollen eine Kontaktreihe in jeder Koordinatenrichtung lückenlos abtasten können.

In der EP 0 989 409 A1 ist eine Vorrichtung zum Prüfen von dicht nebeneinander angeordneten Testpunkten beschrieben. Bei dieser Vorrichtung werden über Prüfpins von der Unterseite der Leiterplatte Testsignale eingespeist. Auf der Oberseite der Leiterplatte werden Kontaktstellen mittels eines einzigen Prüfkopfes kontaktiert. Der Prüfkopf ist mit einer Kamera versehen, um den Prüfling während des Testvorgangs betrachten zu können. Hierzu ist ein Spiegel am Prüfkopf angeordnet, der das Licht vom Prüfling zur Kamera lenkt.

Der Erfindung liegt die Aufgabe zugrunde, den Fingertester nach der WO 03/096037 A1 derart weiterzubilden, dass eng nebeneinander liegende Leiterplattentestpunkte einer unbestückten Leiterplatte ohne Kollisionsgefahr detektierbar sind und dass der Fingertester kostengünstig im Vergleich zu herkömmlichen Testern ist.

Die Aufgabe wird mit den Merkmalen des Anspruchs 1 gelöst. Vorteilhafte Weiterbildungen sind in den Unteransprüchen gekennzeichnet.

Der Erfindung liegt auch die Aufgabe zugrunde, ein Verfahren zum Prüfen von Leiterplatten mit der Vorrichtung zu schaffen, welches schnell und sicher durchführbar ist.

Diese Aufgabe wird mit den Merkmalen des Anspruchs 13 gelöst. Vorteilhafte Weiterbildungen sind in den hiervon abhängigen Unteransprüchen gekennzeichnet.

Der erfindungsgemäße Fingertester sieht vor, mit zwei oder mehreren Prüffingern die einzelnen Kontaktstellen sequenziell abzutasten. Die Prüffinger sind in an sich bekannter Weise mittels jeweils eines Schlittens befestigt, welcher entlang einer Traverse verfahrbar ist.Die Prüffinger können mit ihren Prüfsonden unmittelbar nebeneinander angeordnet werden. Da ein jeder Prüffinger eine optische Detektionseinrichtung aufweist ist, welche den unmittelbaren Bereich, den der Prüffinger prüft, optisch aufnimmt, darf es hierbei nicht zu Kollisionen der optischen Detektionseinrichtungen kommen. Die bei der Erfindung verwendetem Detektionseinrichtungen sind aus einer Kamera sowie einer Lichtlenkeinheit ausgebildet, welche das nach oben reflektierte Licht im Bereich des Messpunktes aus der Vertikalen in die Horizontale umleitet und zu der Kamera führt, die entfernt von der Prüfsonde am Schlitten angeordnet ist.

Erfindungsgemäß sind die optischen Detektionseinrichtungen von der jeweiligen Messstelle bzw. der Oberfläche einer zu untersuchenden Leiterplatte unterschiedlich weit beabstandet bzw. bezüglich der Höhe in unterschiedlichen Ebenen angeordnet. Der Abstand ist dabei so gewählt, dass die unterschiedlichen Ebenen soweit auseinanderliegen, dass selbst bei sehr eng aneinandergefahrenen Schlitten bzw. Prüfsonden die jeweiligen Lichtlenkeinheiten übereinander angeordnet sind, ohne miteinander kollidieren zu können.

Durch die unterschiedlichen Höhen, die die Lichtlenkeinheiten von der Kontaktspitze der Prüffinger haben, ist es möglich, die Blickrichtung von den Lichtlenkeinheiten auf die Oberfläche der Leiterplatte senkrecht auszurichten. Eine Schrägstellung ist nicht notwendig. Hierdurch wird die Qualität des erfassten Bildes gegenüber schräg gestellten Kameras wesentlich verbessert.

Durch die unterschiedlichen Höhen, die die Lichtlenkeinheiten bzgl. der Kontaktspitze der Prüfsonde bzw. einem Messort aufweisen, ist üblicherweise auch der Weg, den das Licht vom Messort zur Kamera zurücklegen muss, unterschiedlich lang. Da aber die Lichtleiteinheiten bzw. die Kamera auf den Messort fokussiert sein muss, wären hierfür unterschiedliche Okularlinsen nötig. Die Okularlinsen sind jedoch teuer und die Zuordnung unterschiedlich fokussierender Okularlinsen zu den in unterschiedlichen Ebenen angeordneten Lichtleiteinrichtungen ist recht aufwendig und teuer.

In einer Weiterbildung der Erfindung wird vorgesehen, zur Kompensation der unterschiedlichen Höhen von dem Messort, die Lichtleiteinheiten in der Länge anzupassen und somit den Weg, den das Licht in der Lichtleiteinheiten nach dem Umlenken in die Horizontale zurücklegt, um das Maß abzukürzen, in dem die Lichteinheiten über der Leiterplatte angeordnet ist. Somit werden die Lichtleiteinheiten von der am nächsten zur Leiterplatte beabstandeten optischen Detektionseinrichtung zu den darüber angeordneten Detektionseinrichtungen immer kürzer. Hierdurch können erfindungsgemäß immer die gleichen Objektivlinsen bzw. die gleichen Objektivanordnungen verwendet werden, was die Vorrichtung erheblich verbilligt.

Durch die Anordnung der Lichtlenkeinheiten in unterschiedlichen Höhen bzw. Ebenen kann es im Laufe des Messbetriebes dazu kommen, dass Prüfsonden sehr eng zueinander benachbart Messungen aufnehmen müssen. Hierbei kann eine weiter oben liegende Lichtlenkeinheit bzw. optische Detektionseinrichtung mit einer entsprechenden Lichtlenkeinheit und einer entsprechenden Kamera von einer darunter liegenden Lichtlenkeinheit abgeschattet werden.

Das erfindungsgemäße Verfahren sieht vor, bei sehr eng benachbarten Leiterplattentestpunkten, die zeitgleich mit unterschiedlichen Prüffingern gemessen werden und einer Abschattung einer oder mehrerer über einer ersten Lichtlenkeinheit angeordneten weiteren Lichtlenkeinheiten das Bild der unteren Lichtlenkeinheit bzw. der unteren Kamera für die optische Steuerung und Überwachung aller in diesem Bereich befindlichen Prüffinger, deren Lichtlenkeinheiten abgeschattet wurden, zu verwenden.

Bei der erfindungsgemäßen Vorrichtung ist von Vorteil, dass durch einfache konstruktive Maßnahmen ein kostengünstiger Aufbau erreicht wird, der ein sicheres Messen ermöglicht und zudem, da auf mögliche Kollisionen weniger Rücksicht genommen werden muss, auch ein schnelleres Messen ermöglicht.

Bei dem erfindungsgemäßen Verfahren ist von Vorteil, dass durch die Verwendung einer Kamera bzw. eines Kamerabildes für das optische Steuern und Überwachen mehrerer Prüffinger die Messung erheblich beschleunigt wird.

Die Erfindung wird anhand einer Zeichnung erläutert. Es zeigen dabei:
- Figur 1:: einen erfindungsgemäßen Prüffinger für einen Fingertester in einer seit- lichen schematisierten Ansicht;

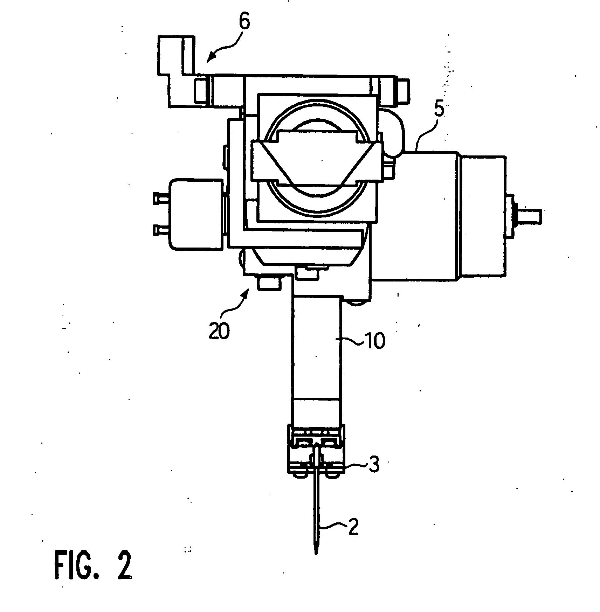

- Figur 2:: den Prüffinger nach Figur 1 in einer Ansicht von vorne;

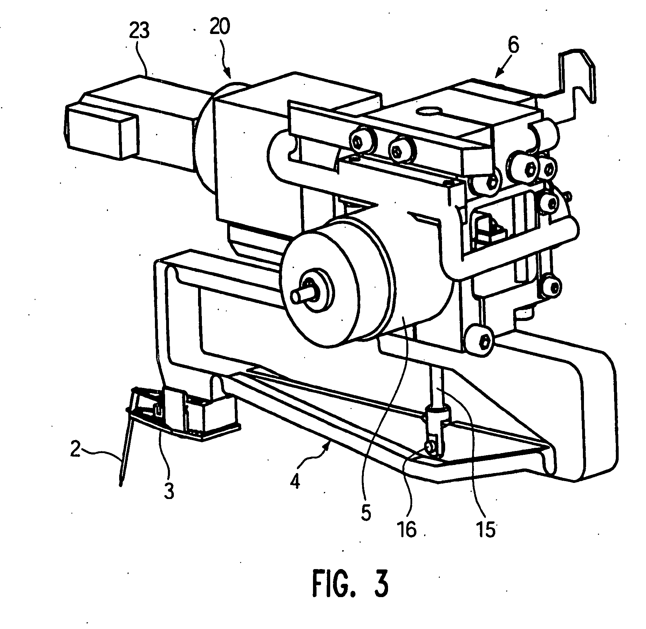

- Figur 3:: den Prüffinger nach Figur 1 in einer perspektivischen Draufsicht von oben;
- Figur 4:: zwei Prüffinger nach Figur 1, die nah benachbart zueinander eine Mes- sung durchführen, wobei die Lichtlenkeinheiten übereinander angeord- net sind;

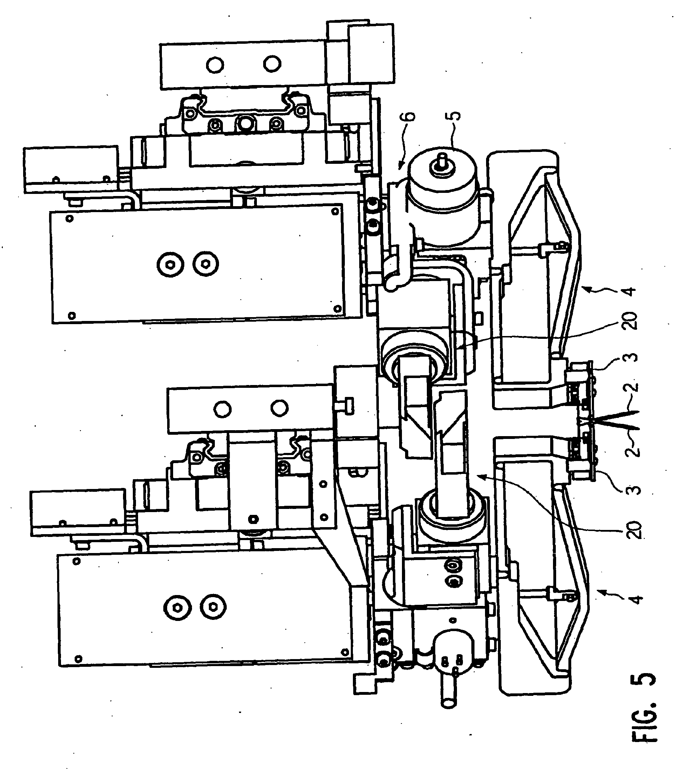

- Figur 5:: die noch weiter übereinander gefahrenen Fingertester nach Figur 4;
- Figur 6:: eine untere optische Detektionseinrichtung mit einer teilgeschnittenen Lichtlenkeinheit und einer Kamera;
- Figur 7:: die Einrichtung nach Figur 6 in einer teilgeschnittenen Ansicht von un- ten;
- Figur 8:: eine obere optische Detektionseinrichtung mit einer Lichtlenkeinheit und einer Kamera in einer schematisierten teilgeschnittenen Seitenansicht;
- Figur 9:: die Einrichtung nach Figur 8 in einer teilgeschnittenen Ansicht von un- ten;
- Figur 10:: eine weitere vorteilhafte Ausführungsform einer optischen Detektion- seinrichtung mit einer Lichtlenkeinheit und einer Kamera mit einer zu- sätzlichen Beleuchtungseinrichtung in einer teilgeschnittenen Ansicht von unten;
- Figur 11:: die Einrichtung nach Figur 10 in einer teilgeschnittenen Seitenansicht;

- Figur 12:: die Einrichtung nach Figur 10 und Figur 11 in einem Querschnitt durch die Lichtleiteinheit im Bereich der zusätzlichen Beleuchtungseinrichtung.

Der erfindungsgemäße Prüffinger 1 weist als Prüfsonde eine Prüfnadel 2 auf, die über ein Sondenplättchen 3 an einer Hebelanordnung 4 angeordnet ist. Ein solches Sondenplättchen geht aus der EP 1 451 594 B1 bzw. der US 2005-001639 A1 hervor. Auf diese Dokumente wird hiermit vollinhaltlich Bezug genommen. Die Hebelanordnung 4 wiederum ist an einer Betätigungseinrichtung 5 befestigt, die Befestigungseinrichtungen 6 zum Befestigen an einem Schlitten besitzt.

Der Schlitten ist Bestandteil eines Fingertesters, wie er beispielsweise aus der EP 0 468 153 A1 hervorgeht. Für jeden Prüffinger ist ein Schlitten vorgesehen. Die Schlitten sind entlang Traversen verfahrbar. Die Traversen überspannen ein Prüffeld, in dem eine zu testende Leiterplatte angeordnet werden kann.

Die Hebelanordnung 4 ist eine geschlossene Hebelanordnung 4, die mit einem im Wesentlichen L-förmigen ersten Tragarm 7, einem Betätigungshebel 8, einem Oberzug 9 und einer Sondenplättchenaufnahme 10 ausgebildet ist.

Der L-förmige Tragarm 7 ist mit seinem langen L-Schenkel 7a unterseitig an der Betätigungseinrichtung 5 befestigt und erstreckt sich von dieser weg. Der kurze L-Schenkel 7b erstreckt sich von dem langen L-Schenkel 7a nach unten, wobei sich von dem kurzen L-Schenkel 7b ein Betätigungsarm 8 etwa parallel zum langen L-Schenkel 7a und in dessen Richtung vom kurzen L-Schenkel 7b wegerstreckt. Der Betätigungsarm 8 ist mit einem Filmscharnier 11 am kurzen L-Schenkel 7b befestigt. Der Betätigungsarm 8 ist in etwa dreieckförmig ausgebildet, wobei er sich dem langen L-Schenkel 7a des Tragarms 7 gegenüberliegend verbreitert und zu einem dem kurzen L-Schenkel 7b gegenüberliegenden Ende 8a hin verjüngt. Der Betätigungsarm 8 erstreckt sich über die Betätigungseinrichtung 5 und über den langen L-Schenkel 7a hinaus. Dem kurzen L-Schenkel 7b gegenüberliegend ist an einem freien Ende 7c des Tragarms 7 ein Oberzug 9 mit einem Filmscharnier 12 angeordnet. Der Oberzug 9 erstreckt sich parallel zum langen L-Schenkel 7a und zum Betätigungsarm 8 und steht mit einem freien Ende 9a etwas über das freie Ende 8a des Betätigungsarms 8 hinaus. Die Sondenplättchenaufnahme 10 ist in etwa L-förmig ausgebildet und ist mit einem freien Ende 10a eines langen L-Schenkels 10b, der sich parallel zum kurzen L-Schenkel 7b des Tragarms 7 erstreckt, über ein Filmscharnier 13 mit dem Oberzug verbunden. Ein kurzer L-Schenkel 10c verläuft parallel zum Oberzug 9 und auf den Betätigungsarm 8 zu und ist mit diesem über ein Filmscharnier 14 verbunden. Der Tragarm 7, der Betätigungsarm 8, der Oberzug 9 und die Sondenplättchenaufnahme 10 bilden die geschlossene Hebelanordnung 4. Am kurzen L-Schenkel 10c der Sondenplättchenaufnahme 10 ist unterseitig das Sondenplättchen 3 angeordnet.

Aus der Betätigungseinrichtung 5 erstreckt sich durch den langen L-Schenkel 7a des Tragarms 7 eine Betätigungsstange 15 hindurch, die mit dem Betätigungsarm 8 über einen Querbolzen 16 die Betätigungsstange 15 im Bereich des Betätigungsarms 8 durchgreift, befestigt ist. Bei einem Bewegen der Betätigungsstange 15 auf die Betätigungseinrichtung 5 zu schwenkt der Betätigungsarm 8 um das Filmscharnier 11 herum, wodurch die Sondenplättchenaufnahme 10 um die Filmscharniere 13 und 14 herum in die entgegengesetzte Richtung nach unten verschwenkt wird, so dass die Prüfnadel 2 auf einer Leiterplatte aufsetzen kann. Hierbei ist die Hebelanordnung 4 bzw. die Hebelanordnung ausbildenden Arme und Züge derart ausgebildet, dass die Kontaktspitze der Prüfnadel 2 eine im wesentlichen rein vertikale Bewegung durchführt, jedoch keine horizontale Bewegung bzw. Querbewegung. Insgesamt führt bei Anziehen der Betätigungsstange 15 durch die Betätigungseinrichtung 5 die Sondenplättchenaufnahme 10 eine Nickbewegung derart durch, dass sich die Kontaktspitze der Prüfnadel 2 nach unten bewegt.

Oberhalb des Prüffingers bzw. der Sondenplättchenaufnahme 10 und des Oberzugs 9 ist eine optische Detektionseinrichtung 20 angeordnet.

Die Detektionseinrichtung 20 besitzt eine Halteeinrichtung 21, die an einer Vorderseite 5a der Betätigungseinrichtung angeordnet ist. Von der Halteeinrichtung 21 erstreckt sich die Detektionseinrichtung 20 parallel zum Oberzug 9 bzw. Betätigungsarm 8. Die Detektionseinrichtung 20 besitzt benachbart zur Halteeinrichtung 21 ein Kameramodul 22, von dem aus sich eine Lichtlenkeinheit 23 parallel zum Oberzug 9 bis über die Prüfnadel 2 erstreckt.

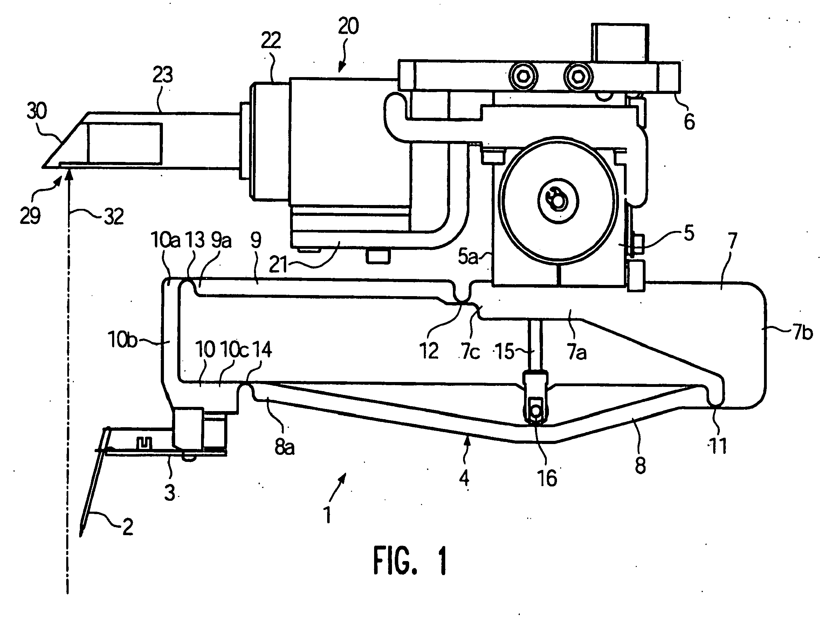

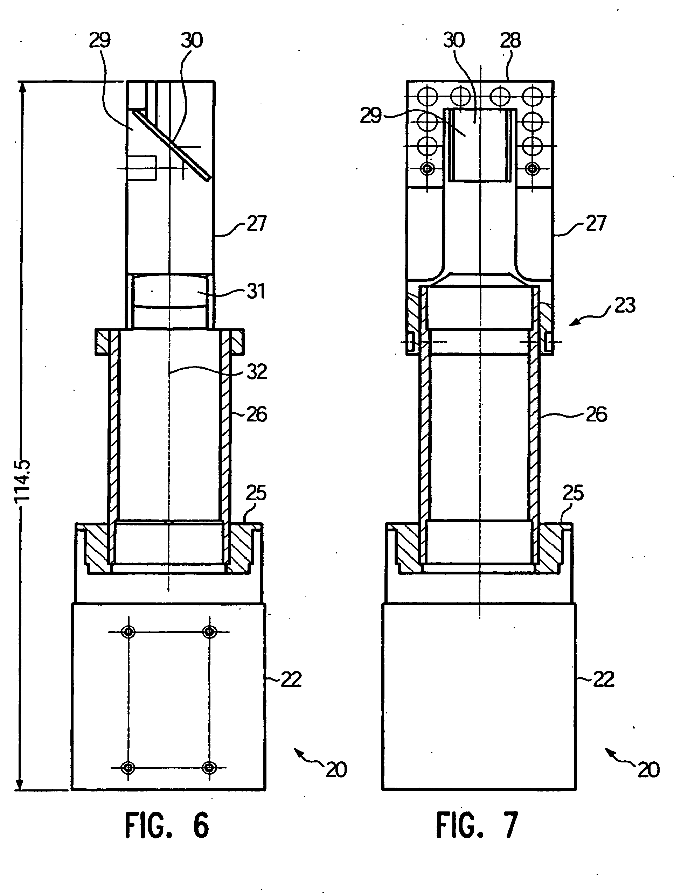

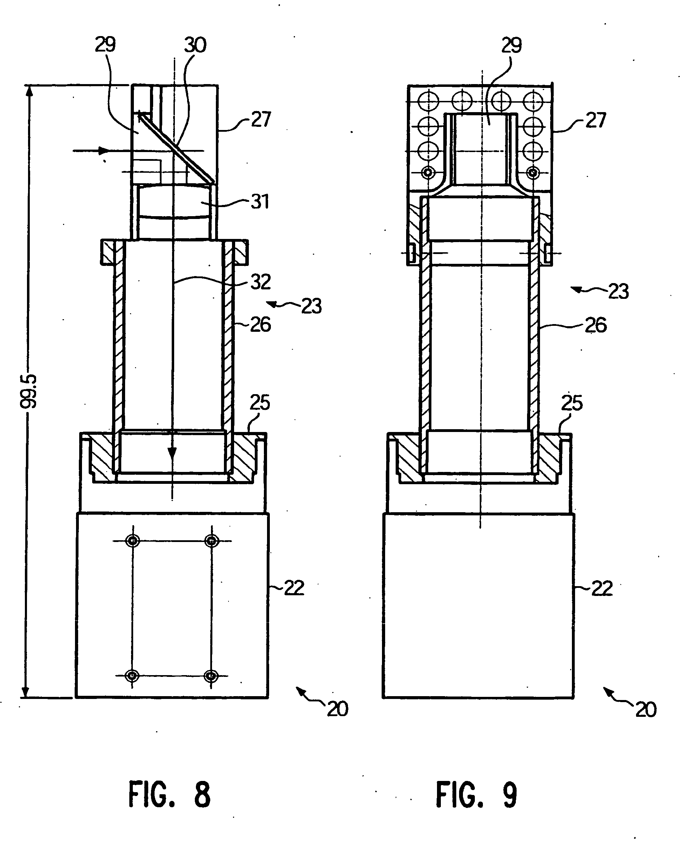

Die Detektionseinrichtung 20 (Fig. 6 bis 12) besteht, wie bereits ausgeführt, aus dem Kameramodul 22 und der Lichtlenkeinheit 23, wobei das Kameramodul 22 ein an sich bekanntes Kameramodul 22 ist, von dem sich die Lichtlenkeinheit 23 von einer Vorderseite 25 des Kameramoduls 22 vom Kameramodul 22 weg erstreckt. Die Lichtlenkeinheit 23 ist im Wesentlichen rohrförmig ausgebildet und besitzt einen ersten Rohrkörper 26, der sich von dem Kameramodul 22 weg erstreckt, wobei an einem freien Ende des Rohrkörpers 26 ein Lichtlenkeinheitkopf 27 aufgesetzt ist. Der Lichtlenkeinheitkopf 27 ist ebenfalls ein Rohrkörper, der im Bereich eines freien Endes 28 eine nach unten, d.h. zu einer Prüfnadel 2 hin weisende beispielsweise quadratische oder rechteckförmige Öffnung 29 besitzt. In dem rohrförmigen Kopf 27 ist oberhalb der Öffnung 29 ein Umlenkspiegel 30 vorhanden, der durch die Öffnung 29 einfallendes Licht in die Horizontale umlenkt und zu einer Objektivlinse 31 führt, die ebenfalls im Kopf 27 benachbart zum Rohrkörper 26 angeordnet ist. Licht, welches vom Bereich der Prüfnadel 2 durch die Öffnung 29 auf den Spiegel 30 fällt, wird in die Horizontale umgelenkt, auf die Objektivlinse 31 geführt und von dieser fokussiert auf eine lichtempfindliche Schicht oder einen lichtempfindlichen Bereich des Kameramoduls 22 fokussiert. Das Kameramodul 22 weist üblicherweise einen optischen Sensor (CCD-Element) mit einer optischen Detektionsfläche und eine zusätzliche Objektivlinse auf. Das Bild der Spitze der Prüfnadel wird mittels der Objektivlinse 31 und gegebenenfalls der weiteren im Kameramodul 22 vorhandenen Objektivlinse auf den optischen Sensor abgebildet. Der Weg des Lichts ist durch den Pfeil 32 in Fig. 8 bzw. Fig. 1 gezeigt. Hieraus kann man erkennen, dass die Blickrichtung in welcher das Kameramodul 22 mit Hilfe des Umlenkspiegels 30 auf die Oberfläche der abzutastenden Leiterplatte blickt, senkrecht zu der Oberfläche der Leiterplatte bzw. senkrecht zu einem Prüffeld steht, das eine Leiterplatte aufnehmen kann.

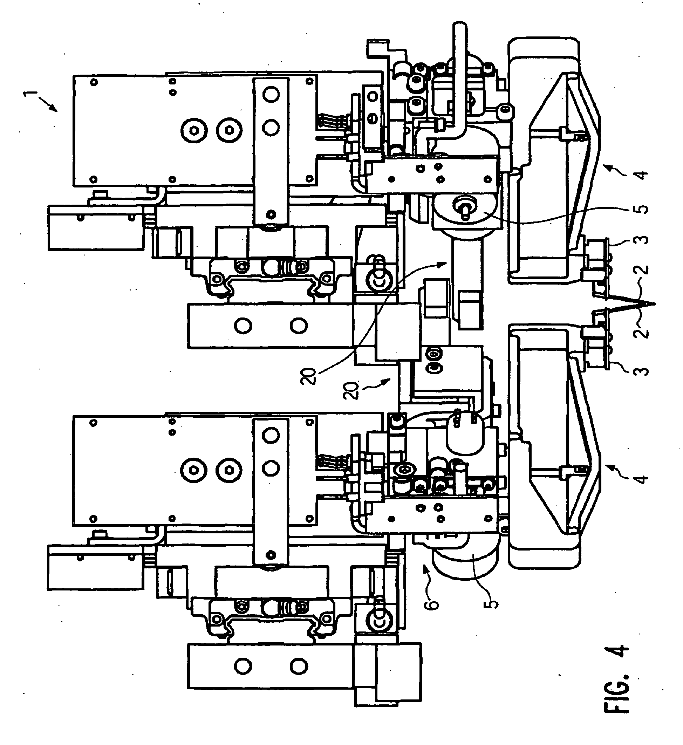

Bei der Verwendung zweier Prüfsonden (Fig. 4) wird bei einer ersten Prüfsonde die Detektionseinrichtung 20 (in Fig. 4 links) im Bereich einer ersten zu den Prüffingern 2 näheren Ebene angeordnet und die Detektionseinrichtung 20 der zweiten Prüfsonde (in Fig. 4 rechts) in einer Ebene darüber derart angeordnet, dass beide Detektionseinrichtungen 20 vertikal so voneinander beabstandet sind, dass sie nicht kollidieren.

Um den Weg des Lichts von einer Leiterplattenoberfläche (nicht gezeigt) bis zu den optischen Detektionsflächen (nicht gezeigt) der Kameramodule 22 gleich lang bleiben zu lassen, ist eine von der Prüfspitze der Prüfnadel 2 weiter beabstandete Detektionseinrichtung 20 (Fig. 8, 9) mit einem Kopf 27 ausgebildet, bei dem sich der Spiegel 30 und damit der Umlenkpunkt des Lichtes näher an der Objektivlinse 31 befindet, als bei einer näher an der Prüfspitze der Prüfnadel 2 angeordneten Detektionseinrichtung 20 (Fig. 6, 7). Der optische Weg des Lichtes von der Spitze der Prüfnadel 2 zur optischen Detektionsfläche wird hiermit bei allen Prüffingern eines Fingertesters konstant gehalten.

Dies erfordert selbstverständlich, dass die Detektionseinrichtung 20 bezüglich der Betätigungseinrichtung 5 weiter vorne in Richtung auf die Prüfnadel 2 angeordnet wird, um den kürzeren Kopf 27 auszugleichen. Die Detektionseinrichtungen 20 sind jeweils mit ihren Spiegeln 30 in vertikaler Flucht zu der Spitze der jeweiligen Prüfnadel 2 angeordnet.

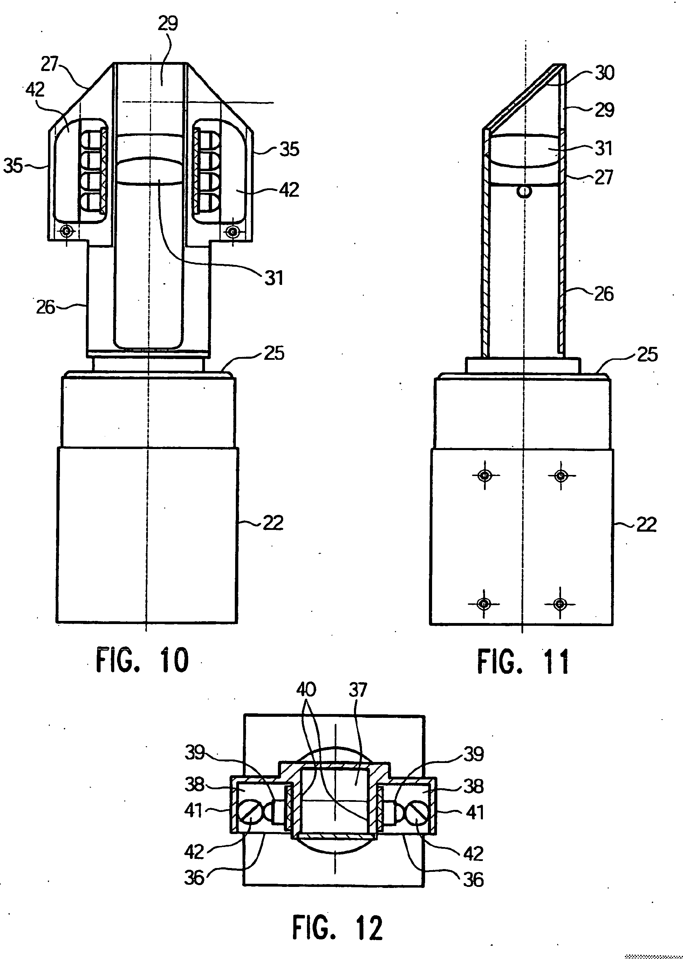

Bei einer vorteilhaften Weiterbildung (Fig. 10 bis 12) der Detektionseinrichtung 20 besitzt der Kopf 27 benachbart zur Öffnung 29 und horizontal beiderseits jeweils eine Verbreiterung 35, wobei die Verbreiterung 35 nach unten zu einer Leiterplatte hinweisend Öffnungen 36 oder Fenster 36 besitzt. In den Öffnungen bzw. hinter den Fenstern 36 sind beiderseits einer die Okularlinse aufnehmende und die Öffnung 29 begrenzenden Röhre 37 Kammern 38 angeordnet, wobei in den Kammern 38 jeweils zumindest eine Leuchtdiode 39 angeordnet ist. Die Leuchtdioden 39 sind beispielsweise an Wandungen 40 angeordnet, die benachbart zu Seitenwandungen der Röhre 37 angeordnet sind. An einer gegenüberliegenden Seitenwandung 41 der Kammern 38 oder davor sind Spiegel 42 angeordnet, die eine raue bzw. matte Oberfläche besitzen. Die Spiegel 42 sind dabei derart orientiert, dass von den Leuchtdioden 39 ausgesendetes Licht nach unten zu einer Leiterplatte gelenkt wird, wobei durch die raue bzw. matte Oberfläche ein diffuses Licht erzielt wird. Das von der Leiterplattenoberfläche reflektierte Licht wird durch die Öffnung 29 hindurchgelenkt, vom Spiegel 30 umgelenkt und durch die Objektivlinse 31 auf eine entsprechende Schicht oder einen entsprechenden Bereich des Kameramoduls 22 geführt. Bei dieser Ausführung ist von Vorteil, dass die Auswerte- und Messsicherheit der Vorrichtung aufgrund des diffusen und von einer benachbart zum optischen Weg liegenden Stelle kommenden Lichtes erheblich erhöht wird.

Bei den oben beschriebenen Ausführungsbeispielen wird als optisches Umlenkelement ein Spiegel 30 verwendet. Im Rahmen der Erfindung ist es auch möglich, anstelle des Spiegels 30 ein Prisma oder ein Bündel gebogener Lichtleiter zum Umlenken des Lichtes vorzusehen.

Bei Fingertestern ist es üblich, zwei oder mehrere Prüffinger pro Traverse anzuordnen (siehe z.B. WO 03/096037 A1). Ein bestimmter Prüffinger kann hierbei jeweils mit einem benachbarten Prüffinger auf einer Traverse bzw. mit den Prüffingern einer benachbarten Traverse kollidieren. Weist eine Traverse z.B. genau zwei Prüffinger auf, so wird eine sichere Kollision der Prüffinger vermieden, wenn die Detektionseinrichtungen 20 in vier unterschiedlichen Niveaus bzw. Höhen angeordnet sind, wobei die beiden Prüffinger einer Traverse zwei unterschiedliche Niveaus und die Prüffinger der benachbarten Traverse wiederum in zwei weiteren unterschiedlichen Niveaus angeordnet sind. Die Detektionseinrichtungen von weiteren Traversen können wieder im gleichen Niveau wie die Detektionseinrichtungen anderer Traversen angeordnet sein, sofern sie nicht die Niveaus der Detektionseinrichtungen an benachbarten Traversen aufweisen. Bei einem Fingertester mit zwei Prüffingern pro Traverse genügen somit vier Niveaus, selbst wenn der Fingertester auf einer Prüfseite mehrere, z.B. zehn Prüffinger aufweist, die auf fünf Traversen verteilt sind. Es genügt somit, als Anzahl der unterschiedlichen Niveaus die doppelte Anzahl der Prüffinger pro Traverse vorzusehen.

Das erfindungsgemäße Verfahren sieht vor, bei einer Situation, bei der Prüfnadeln 2 benachbart zueinander an bzw. auf einer Leiterplatte (nicht gezeigt) messen und hierdurch die Lichtlenkeinheit 23 einer oberen Detektionseinrichtung 20 (in Fig. 4 rechts) durch die Lichtlenkeinheit 23 einer unteren Detektionseinrichtung 20 (in Fig. 4 links) abgeschattet wird, eine Steuerung derart durchzuführen, dass bei der Ermittlung einer Abschattung das Bild der unteren Detektionseinrichtung 20 auch für die Steuerung des zur oberen Detektionseinrichtung 20 gehörenden Prüffinger 1 verwendet wird.

Werden mehr als zwei Prüfsonden verwendet und überschatten sich mehr als zwei Detektionseinrichtungen mit ihren Lichtlenkeinrichtungen, wird die Steuerung so lange durchgeführt, bis alle abgeschatteten Detektionseinrichtungen das Bild der jeweils untersten Detektionseinrichtung für die Steuerung verwenden.

Bei dem erfindungsgemäßen Fingertester ist von Vorteil, dass die Oberfläche einer zu testenden Leiterplatte mit einer darauf senkrecht angeordneten Blickrichtung abgetastet werden kann, wodurch die hierdurch erfasste Abbildung der Oberfläche der Leiterplatte wesentlich weniger Verzerrungen aufweist als wenn die Leiterplatte mit Blickrichtung schräg zur Vertikalen abgetastet werden würde. Hierdurch wird die Auswertung der somit erfassten Bilder einfacher. Eine derart ausgebildete Detektionseinrichtung erlaubt zum einen die Steuerung der Positionierung der Prüfnadel beim Kontaktieren von Leiterplattentestpunkten als auch die Aufnahme einer Abbildung der vollständigen Leiterplatte zur weitergehenden Analyse, beispielsweise zum Vergleich mit synthetischen Bildern, die aus CAD-Daten der zu testenden Leiterplatte hergestellt worden sind. Diesbezüglich wird auf die Deutsche Patentanmeldung 10 2006 005 800.3 verwiesen.

Die vorliegende Erfindung stellt eine Weiterbildung des Verfahrens und der Vorrichtung aus der WO 03/096037 A1 dar. Auf dieses Dokument wird deshalb vollinhaltlich Bezug genommen und es wird in die vorliegende Anmeldung inkorporiert.

Bei dem erfindungsgemäßen Fingertester ist von Vorteil, dass auf einfache und kostengünstige Weise eine Mehrzahl von Prüfsonden in einer Vorrichtung zum Prüfen von unbestückten Leiterplatten verwendet werden können, ohne dass die Fokussierung der einzelnen Okulare geändert werden muss.

Bei dem Verfahren ist von Vorteil, dass bei der Verwendung mehrerer Prüfsensoren mit mehreren Prüffingern verwendet werden können, wobei auch bei einer Überschattung eine sehr schnelle Steuerung möglich ist und alle Prüffinger trotz Abschattung einsetzbar sind.

### Bezugszeichenliste

- 1: Prüffinger
- 2: Prüfnadel
- 3: Sondenplättchen
- 4: Hebelanordnung
- 5: Betätigungseinrichtung
- 6: Befestigungseinrichtung
- 7: Tragarm
- 7a: L-Schenkel
- 7b: L-Schenkel
- 7c: freies Ende von Tragarm 7
- 8: Betätigungsarm
- 8a: Ende des Betätigungsarms 8
- 9: Oberzug
- 10: Sondenplättchenaufnahme
- 11: Filmscharnier
- 12: Filmscharnier
- 13: Filmscharnier
- 14: Filmscharnier
- 15: Betätigungsstange

- 20: Detektionseinrichtung
- 21: Halteeinrichtung
- 22: Kameramodul
- 23: Lichtlenkeinheit

- 25: Vorderseite
- 26: Rohrkörper
- 27: Lichtlenkeinheitkopf
- 28: freies Ende des Lichtlenkeinheitkopfes 27
- 29: Öffnung
- 30: Spiegel
- 31: Objektivlinse
- 32: Pfeil

- 35: Verbreiterung
- 36: Öffnung/Fenster
- 37: Röhre
- 38: Kammer
- 39: Leuchtdiode
- 40: Wandung
- 41: Seitenwandung
- 42: Spiegel

## Patentansprüche

1. Fingertester zum Prüfen von unbestückten Leiterplatten mit zumindest zwei Prüffingern (1), die jeweils eine Prüffsonde (2) besitzen, wobei oberhalb einer jeden Prüfsonde (2) je eine Detektionseinrichtung (20) zum optischen Erfassen der Position von zumindest einer Kontaktspitze der Prüfsonde (2) vorhanden ist, **dadurch gekennzeichnet, dass** die Detektionseinrichtungen (20) der zumindest zwei Prüffinger (1) in unterschiedlichen vertikal beabstandeten Ebenen angeordnet sind, so dass zumindest Bereiche der Detektionseinrichtungen (20), die oberhalb der Prüfsonden (2) angeordnet sind, vertikal fluchtend berührungslos übereinander positionierbar sind.

2. Fingertester nach Anspruch 1,
**dadurch gekennzeichnet,**
**dass** die Detektionseinrichtungen jeweils eine Lichtlenkeinheit (23) mit einem Umlenkelement (30) zum Umlenken des Lichts von einer Oberfläche einer zu prüfenden Leiterplatte auf jeweils eine Detektionsfläche aufweist, wobei der Weg von der Oberfläche der zu prüfenden Leiterplatte bis zur jeweiligen Detektionsfläche für die unterschiedlichen Detektionseinrichtungen konstant ist.

3. Fingertester nach Anspruch 2,
**dadurch gekennzeichnet,**
**dass** jede Detektionseinrichtung (20) ein Kameramodul (22) umfasst an der die Detektionsfläche vorgesehen ist, wobei jede Lichtlenkeinheit (23) eine Öffnung (29) zum Eintritt von reflektiertem Licht von der Oberfläche der Leiterplatte im Bereich der Prüfsonde (2) besitzt und im Strahlengang des vom Umlenkelement (30) umgelenkten Lichts eine Objektivlinse (31) vorhanden ist, die das Licht auf einer optischen Detektionsfläche der Kamera bündelt, wobei der Weg des Lichts von der Oberfläche der Leiterplatte zum Umlenkelement (30) und vom Umlenkelement (30) zur Detektionsfläche (31) unabhängig von der Höhe der Lichtlenkeinheit (23) über der Leiterplatte konstant gehalten ist, wobei zur Kompensation einer größeren Höhe die Lichtlenkeinheit (23) bzw. der Weg vom Umlenkelement (30) zur Detektionsfläche (31) entsprechend einer größeren Höhe verkürzt ausgebildet ist.

4. Fingertester nach Anspruch 2 oder 3,
**dadurch gekennzeichnet,**
**dass** die Umlenkelement als Spiegel, Prisma oder Lichtleiter ausgebildet ist.

5. Fingertester nach einem der Ansprüche 1 bis 4,
**dadurch gekennzeichnet,**
**dass** an der Detektionseinrichtung (20) zumindest eine Leuchteinrichtungen (39) vorgesehen ist, welche diffuses Licht zu einer zu prüfenden Leiterplatte hin aussendet und einen Bereich einer zu prüfenden Leiterplatte, den die Prüfsonde (2) kontaktiert, beleuchtet.

6. Fingertester nach Anspruch 5,
**dadurch gekennzeichnet,**
**dass** die Detektionseinrichtung (20) ein Gehäuse mit einer Öffnung (29) zum Eintritt von der Oberfläche einer zu prüfenden Leiterplatte reflektiertem Licht aufweist, und dass die Leuchteinrichtung benachbart zu dieser Öffnung (29) angeordnet ist.

7. Fingertester nach Anspruch 5 oder 6,
**dadurch gekennzeichnet,**
**dass** die Leuchteinrichtung eine seitlich abstrahlende Lichtquelle und einen Spiegel (42) zum Umlenken des Lichtes in Richtung zur Oberfläche einer zu prüfenden Leiterplatte aufweist, wobei der Spiegel eine matte bzw. rauhe Oberfläche besitzt.

8. Fingertester nach einem der Ansprüche 5 bis 7,
**dadurch gekennzeichnet,**
**dass** die Leuchteinrichtung als Lichtquelle eine oder mehrere Leuchtdioden (39) aufweist.

9. Fingertester nach einem der Ansprüche 2 bis 8,
**dadurch gekennzeichnet,**
**dass** sich die Lichtlenkeinheit (23) von einer Vorderseite (25) des Kameramoduls (22) vom Kameramodul (22) weg erstreckt, wobei die Lichtlenkeinheit (23) rohrförmig ausgebildet ist und einen ersten Rohrkörper (26) besitzt, der sich vom Kameramodul (22) weg erstreckt, wobei an einem freien Ende des Rohrkörpers (26) ein Lichtlenkeinheitkopf (27) aufgesetzt ist, der ebenfalls ein Rohrkörper ist und in dem ein Umlenkelement (30) und eine Objektivlinse (31) angeordnet sind.

10. Fingertester nach einem der vorhergehenden Ansprüche,
**dadurch gekennzeichnet,**
**dass** die Prüfsonde (2) mittels eines Sondenplättchens (3) an einer Hebelanordnung (4) angeordnet ist, welche an einer Betätigungseinrichtung (5) befestigt ist.

11. Fingertester nach einem der Ansprüche 1 bis 10,
**dadurch gekennzeichnet,**
**dass** die optische Detektionseinrichtung (20) mit ihrer Blickrichtung senkrecht auf ein Prüffeld zum Aufnehmen einer unbestückten zu prüfenden Leiterplatte ausgerichtet ist.

12. Fingertester nach einem der Ansprüche 1 bis 11,
**dadurch gekennzeichnet,**
**dass** der Fingertester mehrere Traversen aufweist, an welchen die Prüffinger (1) verfahrbar angeordnet sind, wobei die Anzahl der unterschiedlich vertikal beabstandeten Ebenen, in welchen die Detektionseinrichtungen (20) der Prüffinger (1) angeordnet sind, die doppelte Anzahl der Prüffinger (1) pro Traverse beträgt.

13. Verfahren zum Prüfen von Leiterplatten mit einem Fingertester von Leiterplatten, aufweisend:
- zumindest zwei Prüffinger (1) mit je einer Prüfsonde (2) zum seriellen Kontaktieren von Leiterplattenprüfpunkten, wobei die Prüfsonde (2) mittels einer Bewegungseinrichtung entlang der Oberfläche einer zu prüfenden Leiterplatte verfahrbar ist, wobei
- je eine optische Detektionseinrichtung (20) zum optischen Erfassen der Position einer Kontaktspitze der Prüfsonde (2) eines Prüffingers (1) vorhanden ist, **dadurch gekennzeichnet, dass**
- die Detektionseinrichtung (20) der Prüffinger (1) in unterschiedlichen Ebenen bzw. Höhen zur Oberfläche der Leiterplatte angeordnet sind und
wenn beim Positionieren der Prüfsonden (2) in einer vertikalen Überdeckung der Detektionseinrichtungen (20), bei der zumindest eine erste weiter von der zu prüfenden Leiterplatte beabstandete Detektionseinrichtung (20) von einer näher an der Leiterplatte angeordneten zweiten Detektionseinrichtung (20) bezüglich der Leiterplatte abgeschattet wird, zur Positionierung der Prüfsonde (2) des Prüffingers (1) mit der ersten Detektionseinrichtung (20) die optischen Daten, die von der zweiten Detektionseinrichtung (20) ermittelt werden, verwendet werden.

14. Verfahren nach Anspruch 13,
**dadurch gekennzeichnet,**
**dass** der Lichtweg von einer Leiterplattenoberfläche zu einer Detektionsfläche jeder Detektionseinrichtung (20) unabhängig von der Höhe der Detektionseinrichtung (20) über der Leiterplatte gleich lang gehalten wird **dadurch**, dass das von einer Leiterplatte reflektierte Licht von einem Spiegel (30) umgelenkt wird und zu einer Objektivlinse (31) geführt wird, wobei zur Kompensation einer größeren Höhe einer Detektionseinrichtung (20) von der Leiterplatte der Weg zwischen dem Spiegel (30) und der Objektivlinse (31) um das Maß verkürzt wird, um das der Weg des Lichts durch die größere Höhe von der Leiterplatte zum Spiegel (30) erhöht wird.

15. Verfahren nach Anspruch 13 oder 14,
**dadurch gekennzeichnet,**
**dass** ein Fingertester gemäß einem der Ansprüche 1 bis 12 verwendet wird.

## Claims

1. Finger tester for the testing of non-componented circuit boards with at least two test fingers (1), each having a test probe (2), wherein there is provided above each test probe (2) a detection device (20) for the optical detection of the position of at least one contact tip of the test probe (2), **characterised in that** the detection devices (20) of the two or more test fingers (1) are arranged at different levels spaced vertically apart, so that at least areas of the detection devices (20) located above the test probes (2) may be positioned without contact in vertical alignment above one another.

2. Finger tester according to claim 1,
**characterised in that**
each of the detection devices has a light guide unit (23) with a deflecting element (30) for deflecting the light from a surface of a circuit board to be tested in each case to a detection surface, wherein the distance from the surface of the circuit board to be tested to the respective detection surface is constant for the different detection devices.

3. Finger tester according to claim 2,
**characterised in that**
each detection device (20) includes a camera module (22) on which the detection surface is provided, wherein each light guide unit (23) has an aperture (29) for the entry of reflected light from the surface of the circuit board in the area of the test probe (2), and there is an objective lens (31) in the beam path of the light deflected from the deflecting element (30) which focuses the light on an optical detection surface of the camera, wherein the distance of the light from the surface of the circuit board to the deflecting element (30) and from the deflecting element (30) to the detection surface (31) is held constant irrespective of the height of the light guide unit (23) above the circuit board, wherein to compensate for greater height the light guide unit (23) is shortened or the distance from the deflecting element (30) to the detection surface (31) reduced accordingly.

4. Finger tester according to claim 2 or 3,
**characterised in that**
the deflecting element is in the form of a mirror, prism or fibre-optic conductor.

5. Finger tester according to any of claims 1 to 4,
**characterised in that**
the detection device (20) is provided with one or more illuminating devices (39) which radiate diffuse light towards a circuit board to be tested and illuminate an area of a circuit board to be tested which is contacted by the test probe (2).

6. Finger tester according to claim 5,
**characterised in that**
the detection device (20) has a casing with an aperture (29) for the entry of light reflected from the surface of a circuit board to be tested, and that the illuminating device is provided adjacent to this aperture (29).

7. Finger tester according to claim 5 or 6,
**characterised in that**
the illuminating device has a light source radiating to the side and a mirror (42) for deflecting the light towards the surface of a circuit board to be tested, wherein the mirror has a matt or rough surface.

8. Finger tester according to any of claims 5 to 7,
**characterised in that**
the illuminating device has as light source one or more light-emitting diodes (39).

9. Finger tester according to any of claims 2 to 8,
**characterised in that**
the light guide unit (23) extends from a front side (25) of the camera module (22) away from the camera module (22), wherein the light guide unit (23) is tubular in form and has a first tubular body (26) extending away from the camera module (22), wherein at one free end of the tubular body (26) a light guide unit head (27) is attached, which is also a tubular body and in which a deflecting element (30) and an objective lens (31) are provided. \

10. Finger tester according to any of the preceding claims,
**characterised in that**
the test probe (2) is mounted by means of a probe microchip (3) on a lever arrangement (4), which is fastened to an actuating device (5).

11. Finger tester according to any of claims 1 to 10,
**characterised in that**
the direction of view of the optical detection device (20) is aligned vertically on a test field to scan a circuit board to be tested.

12. Finger tester according to any of claims 1 to 11
**characterised in that**
the finger tester has several cross-bars on which the test fingers are movably mounted, wherein the number of different planes spaced vertically apart, in which the detection devices (20) of the test fingers (1) are arranged, amounts to twice the number of test fingers (1) per cross-bar.

13. Method of testing circuit boards using a finger tester which has:
- at least two test fingers (1), each with a test probe (2) for the serial contacting of circuit board test points, wherein the test probe (2) is able to traverse by means of a movement device along the surface of a circuit board to be tested, wherein
- in each case an optical detection device (20) is provided for the optical scanning of the position of a contact tip of the test probe (2) of a test finger (1),
**characterised in that**
the detection devices (20) of the test fingers (1) are arranged on different levels or heights from the surface of the circuit board, and
in the positioning of the test probes (2) in a vertical coverage of the detection devices (20), in which at least one detection device (20) located further from the circuit board to be tested is shadowed with regard to the circuit board by a second detection device (20) mounted closer to the circuit board, the optical data determined by the second detection device (20) is used by the first detection device (20) for positioning the test probe (2) of the test finger (1).

14. Method according to claim 13,
**characterised in that**
the light path from a circuit board surface to a detection surface of any detection device (20) is kept at a constant length independent of the height of the detection device (20) over the circuit board, due to the fact that light reflected from a circuit board is deflected by a mirror (30) and guided to an objective lens (31), wherein to compensate for a greater height of a detection device (20) from the circuit board, the distance between mirror (30) and the objective lens (31) is reduced by the amount by which the path of the light is increased due to the greater distance between the circuit board and the mirror (30).

15. Method according to claim 13 or 14,
**characterised in that**
a finger tester according to any of claims 1 to 12 is used.

## Revendications

1. Dispositif de test à doigts pour contrôler des cartes à circuits imprimés non garnies, comprenant au moins deux doigts de contrôle (1) qui possèdent chacun une sonde de contrôle (2), dans lequel un moyen de détection respectif (20) est prévu au-dessus de chaque sonde de contrôle (2) pour détecter de manière optique de la position d'au moins une pointe de contact de la sonde de contrôle (2),
**caractérisé en ce que** les moyens de détection (20) desdits au moins deux doigts de contrôle (1) sont agencés dans des plans différents verticalement écartés, de sorte qu'au moins des régions des moyens de détection (20), qui sont agencées au-dessus des sondes de contrôle (2), sont susceptibles d'être positionnées les unes au-dessus des autres en alignement vertical et sans contact.

2. Dispositif de test à doigts selon la revendication 1,
**caractérisé en ce que** les moyens de détection comprennent chacun une unité de déflexion de lumière (23) avec un élément de déflexion (30) pour défléchir la lumière provenant d'une surface d'une carte à circuits imprimés à contrôler vers une surface de détection respective, et **en ce que** le trajet depuis la surface de la carte à circuits imprimés à contrôler jusqu'à la surface de détection respective est constante pour les différents moyens de détection.

3. Dispositif de test à doigts selon la revendication 2,
**caractérisé en ce que** chaque moyen de détection (20) comprend un module de caméra (22) au niveau duquel est prévue la surface de détection, dans lequel chaque unité de déflexion de lumière (23) possède une ouverture (29) pour l'entrée de la lumière réfléchie depuis la surface de la carte à circuits imprimés dans la région de la sonde de contrôle (2), et une lentille objectif (31) est prévue dans le trajet des rayons de la lumière réfléchie par l'élément de déflexion (30), lentille qui focalise la lumière vers une surface de détection optique de la caméra, dans lequel le trajet de la lumière depuis la surface de la carte à circuits imprimés jusqu'à l'élément de déflexion (30) et depuis l'élément de déflexion (30) jusqu'à la surface de détection (31) est maintenu constant indépendamment de la hauteur de l'unité de déflexion de lumière (23) au-dessus de la carte à circuits imprimés, et dans lequel pour la compensation d'une hauteur plus importante, l'unité de déflexion de lumière (23) ou respectivement le trajet depuis l'élément de déflexion (30) jusqu'à la surface de détection (31) est réalisé(e) de manière raccourcie en correspondance de la hauteur plus importante.

4. Dispositif de test à doigts selon la revendication 2 ou 3,
**caractérisé en ce que** l'élément de déflexion est réalisé sous forme de miroir, de prisme ou de guide d'ondes.

5. Dispositif de test à doigts selon l'une des revendications 1 à 4, **caractérisé en ce qu'**au moins un moyen d'éclairage (30) est prévu sur le moyen de détection (20), lequel envoie une lumière diffuse vers une carte à circuits imprimés à contrôler et éclaire une zone d'une carte à circuits imprimés à contrôler contre laquelle la sonde de contrôle (2) vient en contact.

6. Dispositif de test à doigts selon la revendication 5,
**caractérisé en ce que** le moyen de détection (20) comprend un boîtier avec une ouverture (29) pour l'entrée de la lumière réfléchie par la surface d'une carte à circuits imprimés à contrôler, et **en ce que** le moyen d'éclairage est agencé au voisinage de cette ouverture (29).

7. Dispositif de test à doigts selon la revendication 5 ou 6,
**caractérisé en ce que** le moyen d'éclairage comprend une source de lumière qui éclaire latéralement et un miroir (42) pour défléchir la lumière en direction de la surface d'une carte à circuits imprimés à contrôler, ledit miroir possédant une surface mate ou rugueuse.

8. Dispositif de test à doigts selon l'une des revendications 5 à 7, **caractérisé en ce que** le moyen d'éclairage comprend une ou plusieurs diodes électroluminescentes (39) à titre de source de lumière.

9. Dispositif de test à doigts selon l'une des revendications 2 à 8, **caractérisé en ce que** l'unité de déflexion de lumière (23) s'étend depuis une face antérieure (25) du module de caméra (22) en s'éloignant du module de caméra (22), dans lequel l'unité de déflexion de lumière (23) est réalisée sous forme tubulaire et possède un premier corps tubulaire (26) qui s'étend en éloignement du module de caméra (22), dans lequel une tête (27) d'une unité de déflexion de lumière est posée sur une extrémité libre du corps tubulaire (26), tête qui est également un corps tubulaire et dans laquelle sont agencés un élément de déflexion (30) et une lentille objectif (31).

10. Dispositif de test à doigts selon l'une des revendications précédentes,
**caractérisé en ce que** la sonde de contrôle (2) est agencée au moyen d'une plaquette de sonde (3) sur un agencement à levier (4) qui est fixé sur un système d'actionnement (5).

11. Dispositif de test à doigts selon l'une des revendications 1 à 10, **caractérisé en ce que** le moyen de détection optique (20) est orienté avec une direction d'observation perpendiculaire à un champ de contrôle à capter sur une carte à circuits imprimés non garnie qu'il s'agit de contrôler.

12. Dispositif de test à doigts selon l'une des revendications 1 à 11, **caractérisé en ce que** le dispositif de test à doigts comprend plusieurs traverses sur lesquelles les doigts de contrôle (1) sont agencés en translation, et le nombre des plans différents écartés verticalement dans lesquels sont prévues les doigts de contrôle (1) du moyen de détection (20) est le double du nombre des doigts de contrôle pour chaque traverse.

13. Procédé pour contrôler des cartes à circuits imprimés avec un dispositif de test à doigts pour cartes à circuits imprimés, comprenant :
- au moins deux doigts de contrôle (1) avec chacun une sonde de contrôle (2) pour établir un contact série avec des points de contrôle sur des cartes à circuits imprimés, tels que la sonde de contrôle (2) est déplaçable à l'aide d'un moyen de déplacement le long de la surface d'une carte à circuits imprimés à contrôler,
- il est prévu un moyen de détection optique respectif (20) pour la détection optique de la position d'une pointe de contact de la sonde de contrôle (2) d'un doigt de contrôle (1),
**caractérisé en ce que**
les moyens de détection (20) des doigts de contrôle (1) sont agencés dans des plans différents ou à des hauteurs différentes par rapport à la surface de la carte à circuits imprimés, et
lorsque, lors du positionnement des sondes de contrôle (2) avec un recouvrement vertical des moyens de détection (20) dans lequel au moins un premier moyen de détection (20) écarté plus loin de la carte à circuits imprimés à contrôler est masqué vis-à-vis de la carte à circuits imprimés par un second moyen de détection (20) agencé plus près de la carte à circuits imprimés, pour le positionnement de la sonde de contrôle (2) du doigt de contrôle (1) avec le premier moyen de détection (20), on utilise les données optiques qui sont déterminées par le second moyen de détection (20).

14. Procédé selon la revendication 13,
**caractérisé en ce que** le trajet de la lumière depuis une surface de la carte à circuits imprimés jusqu'à une surface de détection de chaque moyen de détection (20) est maintenu à une longueur égale indépendamment de la hauteur du moyen de détection (20) au-dessus de la carte à circuits imprimés, grâce au fait que la lumière réfléchie par une carte à circuits imprimés est défléchie par un miroir (30) et menée vers une lentille objectif (31), et pour la compensation d'une plus grande hauteur d'un moyen de détection (20) depuis la carte à circuits imprimés, le trajet entre le miroir (30) et la lentille objectif (31) est raccourci de la mesure selon laquelle le trajet de la lumière est augmenté en raison de la plus grande hauteur de la carte à circuits imprimés par rapport au miroir (30).

15. Procédé selon la revendication 13 ou 14,
**caractérisé en ce que** l'on utilise un dispositif de test à doigts selon l'une des revendications 1 à 12.
